# EUROPEAN PATENT APPLICATION

(11) **EP 4 349 783 A1**
(43) Date of publication of application: **10.04.2024**
(21) Application number: 23192009.1
(22) Date of filing: 17.08.2023
(51) Int. Cl.: C01G 21/00

(54) **A PROCESS FOR SYNTHESIS OF B-SITE DOPED ABX3 PEROVSKITE NANOCRYSTALS**

(30) Priority: 24.08.2022 IN 202221048238
(71) Applicant: Indian Oil Corporation Limited, 400 051 Mumbai Bandra (East) (IN)
(72) Inventor: DUTTA, Anirban, 121007 Faridabad (IN); VYAS, Mukesh Kumar, 121007 Faridabad (IN); OTA, Jyotiranjan, 121007 Faridabad (IN); HAIT, Samik Kumar, 121007 Faridabad (IN); KANNAN, Chandrasekaran, 121007 Faridabad (IN); RAMAKUMAR, Sankara Sri Venkata, 121007 Faridabad (IN)
(74) Representative: Turner, Craig Robert

(57) **Abstract**

The present invention relates to a process for the synthesis of B-site doped ABX₃ perovskite nanocrystals. The process comprises the steps of loading non-halide precursors of A, B, and dopant in three neck flasks along with long chain acid and olefin, purging of the reaction mixture under heating, and finally injection of alkylammonium chloride stock solution in the reaction mixture at a desired temperature. Introducing transition metal such as Mn and other rare earths, etc., as dopants in the perovskite nanocrystals to induce a new optical window.

## Description

### FIELD OF THE INVENTION

The present invention relates to a process for the preparation of B-site doped ABX₃ perovskite nanocrystals. More particularly, the present invention provides a process for the preparation of doped ABX₃ perovskite nanocrystals, wherein X=Chlorine (Cl), Bromine (Br), and Iodine (I).

### BACKGROUND OF THE INVENTION

Various literature describes the preparation of several doped ABX₃ nanocrystals using various methods, which include Hot injection (HI), Ligand Assisted Re-precipitation (LARP), ultrasonication, mechano-chemical, etc. These doped nanocrystals prepared through method other than HI suffer from low photoluminescence quantum yield (PLQY) and poor crystallinity. Kovalenko et al. (Nano Lett. 2015, 15, 3692-3696) invented the HI approach for ABX₃ (A=Cs, B=Pb and X=Cl, Br, I) perovskite nanocrystals and this remained the most studied approach for the synthesis of perovskite nanocrystals. This method is termed here as a traditional HI approach. Manganese remained the first dopant to be introduced in this system and Mn doping in CsPbX₃ is first reported by Klimov et al. (J. Am. Chem. Soc. 2016, 138, 14954-14961) where they followed this traditional HI approach. The same approach is also followed for doping other dopants by many researchers. The same method is accepted widely for the synthesis of doped nanocrystals. For synthesizing Mn-doped nanocrystals, manganese chloride (MnCl₂), lead chloride (PbCl₂), and octadecene (ODE) solvent are loaded in a three-neck flask. Then the temperature of the reaction mixture is set at 100-120°C and purged with argon/nitrogen to remove moisture and oxygen from the system. This is followed by injection of oleic acid (OA), oleylamine (OLA), and trioctylphosphine (TOP) for solubilizing the precursor and stabilizing the formed nanocrystals. The reaction is triggered by injecting a preformed cesium-oleate (Cs-oleate) stock solution at the desired temperature. Finally, the reaction is quenched by dipping the flask in an ice bath. This traditional HI approach has the following disadvantages:
1. Due to high Pb-Cl and Mn-Cl bond energy, TOP (Klimov et al. J. Am. Chem. Soc. 2016, 138, 14954-14961) or excess OA and OLA (Son et al. Nano lett. 2016, 16, 7376-7380) are used for the solubilization of the precursor. Phosphine is expensive as well as an extensive toxic chemical. Phosphine is not an industry benign chemical and has a lot of environmental hazards.
2. The acid-amine ion pair is responsible for solubilization of lead halide precursor, but the reaction between acid and amine is exothermic. Hence, on increasing the reaction temperature, reprecipitation of the lead halide precursor is observed (Manna et al. ACS Nano 2018, 12, 1704-1711). This creates a major problem in scalability and multiple times it is required to solubilize the Pb and Mn precursor before triggering the reaction.
3. Lead halide is always taken in excess than Cs to meet 1: 1:3 Cs to Pb to X ratio in CsPbX₃ nanocrystals (Kovalenco et al. Nano Lett. 2015, 15, 3692-3696). This restricts the yield of the reaction and results in lower yield and high precursor loss.
4. Soon after Cs-oleate injection, the reaction is needed to be quenched by dipping the reaction flask in an ice bath to maintain optical and phase property. This step is not at all industrially feasible process for a large-scale reaction when quick reduction of temperature is required for a large volume of reaction mixture.
5. To achieve <1% Mn doping in crystal, 100% or more Mn-precursor (with respect to lead halide) is taken for reaction, which accounts for the loss of precursor. This results in a lot of Mn-precursor loss which leads to cost enhancement of the process.

However, several modifications have been done in the art to improve the doping process.

CN108753286 reported Mn doped CsPbCl₃ perovskite nanocrystals prepared by microwave-assisted thermal injection method. CN108865126 modified the traditional HI approach and obtained Mn doped CsPbCl₃ and CsPbCl₃₋ₓBrₓ nanocrystals. This was done by taking different stock solutions. One sock solution contains PbCl₂ and MnCl₂ (Pb:Mn=1:2) along with OA, OLA and TOP; and other stock solution contains Cs-oleate; mixing them at 190°C results in Mn doped CsPbCl₃ nanocrystals. For Mn doping in CsPbCl₃₋ₓBrₓ nanocrystals, the process remains same. Instead of only PbCl₂, separate PbBr₂ and PbCl₂ precursor solutions were prepared. Different amounts of PbCl₂ and PbBr₂ stock solutions were mixed and Cs-oleate was added to this mixed stock solution at 190°C for triggering the reaction. By varying the stock solution amount, the chloride to bromide ratio in the doped nanocrystals was adjusted. The reaction was quenched by ice cooling. The process involved Mn and Pb precursor loss as well as use of phosphine, which put a bar on their commercial feasibility.

CN108929685A relates to a preparation method of Mn-doped CsPbCl₃ perovskite quantum dot comprising the steps of putting the Cs₂CO₃ with octadecene and oleic acid in the three-necked bottle, heating to 95-105 degrees centigrade; raising the temperature to 135-145 degrees centigrade; then heating to 175-185 degrees centigrade, rapidly injecting oleic acid cesium precursor, reacting for 2-4 min, and cooling in a fast-cooling bath. CN110218561A relates to a method of improving manganese doping CsPbCl₃, wherein the method comprises preparing a cesium precursor solution; combining octadecene, oleic acid, oleylamine, trioctyl phosphine, lead chloride, manganese chloride and nickel chloride Mixing; forming Ni and Mn double doped CsPbCl₃ nanocrystals; Obtaining Ni and Mn double doped CsPbCl₃ nanocrystalline solution.

WO2017100950A1 relates to methods of forming quantum dots of the formula CsPbX₃, wherein X is a halogen (CI, Br, or I). It comprises lead precursors such as lead (II) oleate and lead (II) stearate, cesium precursors such as cesium oleate and cesium stearate, and halide precursors such as benzyl halide. The molar ratio of cesium: lead (II) is from about 10:1 to about 1:10. Lijia Liu *et al.* discloses preparation of Mn-doped CsPb(Br/Cl)₃ nanocrystals with Cs₂CO₃ and PbAc₂ as non-halide precursors in 1:1 ratio and doping of Mn is done using MnCl₂. The synthesis is performed at room temperature and hence ice-cooling/quenching step is not required. It also does not involve use of phosphine.

David Parobek *et al.* relates to the synthesis of Mn-doped CsPbBr₃ nanocrystals via the formation of an intermediate structure (L₂[Pb₁₋ₓMnₓ]Br₄, L=ligand) before the hot-injection of the Cs precursor, which contains the same Mn-Br coordination present in Mn-doped CsPbBr₃ nanocrystals. A strong correlation was observed between the Mn luminescence intensities of L₂[Pb₁₋ₓMnₓ]Br₄ and Mn-doped CsPbBr₃ nanocrystals, suggesting the possible role of L₂[Pb₁₋ₓMnₓ]Br₄ as the structural precursor to Mn-doped CsPbBr₃ nanocrystals. Ping Yang *et al.* relates to Mn:CsPb(Cl/Br)₃ nanocrystals (NCs) with different halogen ratios obtained by one-pot hot injection synthesis and halogen ion exchange. Xinmei Hou *et al.* relates to an improved hot injection technique, namely microwave-assisted hot injection, for mass production of Mn²⁺-doped CsPbCl₃ (Mn²⁺:CsPbCl₃) perovskite nanocrystals (NCs). YiwenZhang *et al.* discloses a simplified solid-state mechanochemical approach to synthesize Mn-doped CsPbCl₃ nanocrystals and investigates the structure and luminescence properties of the as-synthesized nanocrystals. Xiaoshang Tang *et al.* discloses Mn-doped CsPbX₃ (X = Br, Cl) quantum dots (QDs) were synthesized at room temperature via a facile strategy by introducing dimethyl sulfoxide (DMSO)-MnBr₂/PbX₂ composite as a precursor.

Narayan Pradhan *et al.* discloses facts related to selecting the precursors and their ratios, the reaction temperature, and some tricks for obtaining high-quality CsPbX₃ nanocrystals. For deaerating the mixture, purging with argon or nitrogen is required at a minimum temperature (typically 100-120°C). The ratio of Pb to Cs ideally might be chosen as 1:1, and in this case, alkylammonium halides might be used for supplying adequate halide ions. These reactions can be performed by injecting Cs(I) precursor or halide precursor at high temperature for nucleating respective perovskite nanocrystals, keeping all other reagents in the reaction flask. Andries Meijerink *et al.* discloses preparation of Mn-doped CsPbCl₃ perovskite nanocrystals with CsAc and PbAc₂ as non-halide precursors used in equimolar amount and doping of Mn is done using MnAc₂ at an amount of 5%. The synthesis is performed at room temperature and hence icecooling/quenching step is not required. It also does not involve use of phosphine. Oleic acid (OA) and oleylamine (OLAM) were chosen as ligands and reaction is performed under N₂ atmosphere. The yield obtained is 70%. Although the above-mentioned methods have been used to overcome some of the inherent drawbacks, most of the challenges are still existing. In compared to all the methods, the inventors report a novel, synthetic process to overcome the above-mentioned issues related to traditional HI approach. Some of the advantages of the process of the present invention over all other reported HI approach include no use of phosphine, no reprecipitation of lead precursor, 100% yield (with respect to Pb/Cs precursor), no ice quenching requirement, and Mn-doping with minimal amount of Mn precursor loading (5-50% with respect to Pb/Cs precursor) for intense Mn d-d emission.

Further, traditional synthesis process for Mn-doped CsPbX₃ perovskite nanocrystals is associated with the following problems:
1. Precursor loss and low yield: Generally, Mn and Pb precursor is taken in large amount and Cs remained the limiting reagent. Hence, excess Pb and Mn precursors remain unreacted and wasted during purification process, which results in low yield of the precursor.
2. Low precursor solubility: Low precursor solubility of Mn halide and lead halide requires more expensive capping agent. For lead chloride, toxic phosphine ligands are used to make the precursor soluble. Moreover, the precursor precipitation appears on increasing the reaction temperature and to solubilize the precursor more expensive capping agents are added.
3. Ice quenching: Doped perovskite nanocrystals are formed by ionic metathesis reaction and remained very fast. These reactions require ice quenching to stop the reaction which remain a major drawback for their scalability.

All these issues create problem in their large-scale production of perovskite nanocrystals. The process of the present invention overcomes the aforementioned drawbacks.

### SUMMARY OF THE INVENTION

The present invention describes a process the preparation of B-site doped ABX₃ perovskite nanocrystals, wherein the process comprises: a) loading non-halide precursors of A, B, and dopant in three neck flasks along with long chain acid and olefin; b) purging of the reaction mixture under heating; and c) finally injecting alkylammonium chloride stock solution in the reaction mixture at a desired temperature.

### TECHNICAL ADVANTAGES OF THE INVENTION:

The advantages of the synthesis over the cited prior arts are as follows:
(a) The precursor loss and low yield is overcome by taking non-halide precursors of Cs and Pb in 1:1 ratio and 5 to 50% of Mn precursor with respect to Cs/Pb. The reactions are triggered by adding halide precursor from outside. This leads to maximum product formation and minimum loss of precursor.
(b) To mitigate the solubility problem associated with the lead halide precursor, non-halide precursors are used. The non-halide precursors react with the long chain acids and generate respective carboxylates. These carboxylates are highly soluble in organic medium and never precipitate out. Therefore, there is no salt re-precipitation.
(c) Reaction is initiated by injecting alkylammonium halide, which acts as a passivating agent and stabilize these nanocrystals. Hence, ice-quenching is not required to stop the reaction.
(d) The process of the present invention provides maximum product conversion, no use of toxic phosphine ligands, easy scalability, and a yield of 97.3%.

### OBJECTIVE OF THE INVENTION:

The primary objective of the present invention is to provide a process for preparation of D-doped ABX₃ perovskite nanocrystals or B-site doped ABX₃ perovskite nanocrystals, the process comprising:
(a) loading non-halide precursors of A, B and dopant (D) in a three-neck flask along with a long chain acid and a linear alpha olefin solvent to form a reaction mixture;
(b) purging the reaction mixture with an inert gas at a temperature in a range of 100-160°C for 30 minutes;
(c) injecting an alkylammonium halide solution in the reaction mixture at a temperature in a range of 80-200°C;
(d) annealing the reaction mixture for 5 seconds to 1 hour and cooling down naturally; and
(e) precipitating the D-doped ABX₃ nanocrystals.

### BRIEF DESCRIPTION OF THE DRAWINGS

Figure 1 relates to process flow diagram of the present invention.
Figure 2 relates to UV-Vis absorbance spectra of Mn-doped CsPbCl₃₋ₓBrₓ nanocrystals.
Figure 3 relates to PL spectra of Mn-doped CsPbCl₃₋ₓBrₓ nanocrystals.
Figure 4 relates to PLE spectra Mn-doped CsPbCl₃₋ₓBrₓ nanocrystals.
Figure 5 relates to Powder XRD Pattern of Mn-doped CsPbCl₃₋ₓBrₓ nanocrystals.
Figure 6 relates to weight loss profile of the synthesized nanocrystals in thermogravimetric analysis.

### DETAILED DESCRIPTION OF THE INVENTION

Those skilled in the art will be aware that the present disclosure is subject to variations and modifications other than those specifically described. It is to be understood that the present disclosure includes all such variations and modifications. The disclosure also includes all such steps of the process, features of the system, referred to or indicated in this specification, individually or collectively and all combinations of any or more of such steps or features.

### Definitions

For convenience, before further description of the present disclosure, certain terms employed in the specification, and examples are collected here. These definitions should be read in the light of the remainder of the disclosure and understood as by a person of skill in the art. The terms used herein have their meanings recognized and known to those of skill in the art, however, for convenience and completeness, particular terms and their meanings are set forth below.

The articles "a", "an" and "the" are used to refer to one or to more than one (i.e., to at least one) of the grammatical object of the article.

The terms "comprise" and "comprising" are used in the inclusive, open sense, meaning that additional elements may be included. It is not intended to be construed as "consists of only".

Throughout this specification, unless the context requires otherwise the word "comprise", and variations such as "comprises" and "comprising", will be understood to imply the inclusion of a stated element or step or group of element or steps but not the exclusion of any other element or step or group of element or steps.

The term "including" is used to mean "including but not limited to". "Including" and "including but not limited to" are used interchangeably.

Unless defined otherwise, all technical and scientific terms used herein have the same meaning as commonly understood by one of ordinary skill in the art to which this disclosure belongs. Although any methods and materials similar or equivalent to those described herein can be used in the practice or testing of the disclosure, the preferred methods, and materials are now described. All publications mentioned herein are incorporated herein by reference.

The present disclosure is not to be limited in scope by the specific embodiments described herein, which are intended for the purposes of exemplification only. Functionally equivalent products and processes are clearly within the scope of the disclosure, as described herein.

The present invention discloses a process for preparation of D-doped ABX₃ perovskite nanocrystals or B-site doped ABX₃ perovskite nanocrystals. The process comprises:
(a) loading non-halide precursors of A, B and dopant (D) in a three-neck flask along with a long chain acid and a linear alpha olefin solvent to form a reaction mixture;
(b) purging the reaction mixture with an inert gas at a temperature in a range of 100-160°C for 10 to 60 minutes;
(c) injecting an alkylammonium halide solution in the reaction mixture at a temperature in a range of 80-200°C;
(d) annealing the reaction mixture for 5 seconds to 1 hour and cooling down naturally; and
(e) precipitating the D-doped ABX₃ nanocrystals.

In another embodiment, the process further comprises preparation of D-doped AB¹_{1-y}B²_{y}X₃ perovskite nanocrystals, wherein B¹ comprises silver (Ag), copper (Cu), indium (In), gold (Au), thalium (Tl), sodium (Na) and potassium (K); B₂ comprises indium (In), bismuth (Bi) and antimony (Sb); and y = 0 to 1.

In yet another embodiment, A is selected from caesium (Cs), methylammonium (MA) and formamidinium (FA); and B is lead (Pb). Further, X is selected from chlorine (Cl), bromine (Br) and iodine (I).

In another embodiment, dopant (D) is selected from manganese (Mn), nickel (Ni), cobalt (Co), copper (Cu), iron (Fe), magnesium (Mg), beryllium (Be), calcium (Ca), strontium (Sr), barium (Ba), bismuth (Bi), antimony (Sb), cerium (Ce), samarium (Sm), europium (Eu), terbium (Tb), dysprosium (Dy), erbium (Er), ytterbium (Yb), zinc (Zn), cadmium (Cd), thallium (Tl), tin (Sn). The dopant (D) comprises transition metal such as Mn, Ni, Fe, Cu etc. and rare earth metals such as Yb, Ce, La etc. and are introduced in perovskite nanocrystals to induce a new optical window and enhance stability.

In another embodiment, the non-halide precursor source is selected from carbonate, acetate, nitrate, acetylacetonate, oleate, undecylenate, myristate, laurate, or palmitate.

In another embodiment, the long chain acid is selected from oleic acid, undecylenic acid, dodecanoic acid, hexadecanoic acid, or hexadecanoic acid. The linear alpha olefin solvent is selected from 1-decene, 1-dodecene, 1-tetradecene, 1-hexadecene, or 1-octadecene.

In another embodiment, the alkylammonium halide is selected from chloride or bromide or iodide salts of octylammonium, oleylammonium, dodecylammonium, dodecylamine, dihexylammonium, dioctylammonium, didecylammonium, or dioctdecylammonium. These alkylammonium halide act as a passivating agent and stabilizes these nanocrystals. Therefore, no immediate quenching of the reaction is required.

In yet another embodiment, the process includes no use of phosphine and no re-precipitation of lead precursor.

In yet another embodiment, the non-halide precursors A and B are taken preferably in the 1:1 ratio and Mn precursor ranges from 5 to 50 wt.% with respect to A or B.

In yet another embodiment, the non-halide precursors react with the long chain acids and generate respective carboxylates. These carboxylates are highly soluble in organic medium (1-decene, 1-dodecene, 1-tetradecene, 1-hexadecene, or 1-octadecene) and never precipitate out in the temperature range of 80-200°C.

In another embodiment, the invention can be extended to other doped perovskite materials such as D-doped ABCl₃₋ₓBrₓ (D=Mn, A=Cs, B=Pb, and x = 1 to 3).

### EXAMPLES:

Having described the basic aspects of the present invention, the following non-limiting examples illustrate specific embodiments thereof. Those skilled in the art will appreciate that many modifications may be made in the invention without changing the essence of invention.

### Example 1: Synthesis of oleylammonium chloride stock solution

In a typical synthesis, 40 ml of oleylamine was taken in a 100 ml 3-neck reaction flask placed in a heating mantel connected with a programmed temperature controller. One neck of the reaction flask was fitted with a temperature sensor, second neck was connected with an air-condenser, and the third neck was left open. Then 4 ml HCl (37% v/v) was injected in the reaction flask. Reaction of HCl with oleylamine results into a solid salt residue. To remove water from the system, reaction mixture was heated at 120°C for 30 minutes. Then the third neck of the flask was closed with rubber septum and nitrogen was purged in the flask by a needle. Finally, the temperature was increased to 150°C, and the reaction mixture was heated further for 30 minutes. Then the reaction temperature was decreased to 100°C and the resulting stock solution was collected under hot condition in an airtight syringe and stored in a deaerated 100 ml flask fitted with a screw type septum. On cooling down to room temperature, the stock solution was solidified. Solidified salt was melted at 80°C before using it for the synthesis of nanocrystals.

### Example 2: Synthesis of oleylammonium bromide stock solution

The synthesis of oleylammonium bromide was same as Example 1. To have same salt concentration like oleylammonium chloride, 5.1 ml HBr (47% v/v) was used instead of 4 ml HCl. Rest of the procedure remains same.

### Example 3: Synthesis of Mn-doped CsPbCl₃ nanocrystals

In a typical synthesis 0.2 mmol of Cs₂CO₃, 0.4 mmol of lead acetate tetrahydrate Pb(II)(OAC)₂.3H₂O and 0.01 to 0.1 mmole manganese(II) acetate tetrahydrate (Mn(II)(OAC)₂.4H₂O) along with 30 ml of octadecene and 2 ml of oleic acid were taken in a 100 ml three necked reaction flask. The reaction mixture was purged with flow of N₂ at 100-160°C for 30 minutes. The temperature of the reaction flask was further increased to 80-200°C and the reaction was triggered by injecting 2 ml preformed stock solution of oleylammonium chloride. After 1-5 minutes, the heating mantel was removed, and the reaction flask was allowed to cool naturally. Cooled reaction mixture was transferred into a 50 ml centrifuge tube and 10 ml anhydrous ethyl acetate was added to it. The resultant mixture was centrifuged at 10000 rpm for 10 minutes. Finally, the supernatant was discarded, and the precipitated nanocrystals were dispersed and harvested in hexane/ toluene/ chloroform.

### Example 4: Synthesis of Mn doped CsPbCl₃₋ₓBrₓ nanocrystals

Mn doped CsPbCl₃₋ₓBrₓ nanocrystals were prepared by following the method stated in Example 3. For obtaining different Cl to Br ratio, the oleylammonium chloride to oleylammonium bromide ratio was adjusted accordingly.

### Example 5: Uv-vis Absorbance Spectra

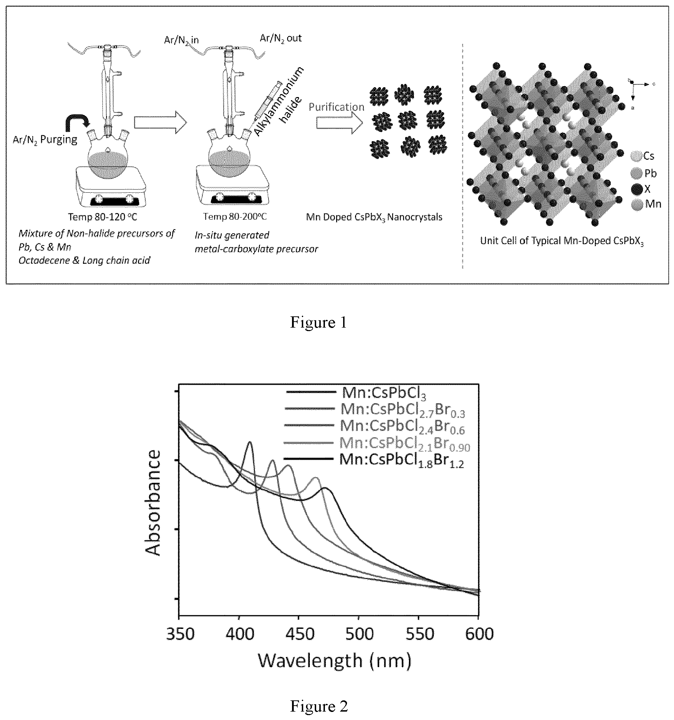

Figure 2 presents UV-Vis absorbance spectra of the Mn-doped nanocrystals. With the increase in bromide content of the nanocrystals, red shifting of the spectra is observed, which indicates lowering of the band gap on bromide alloying.

### Example 6: Photoluminescence (PL) Spectra

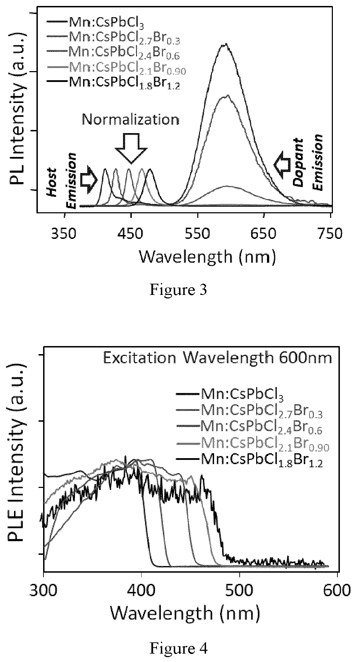

Figure 3 presents PL spectra of the Mn-doped CsPbCl₃₋ₓBrₓ nanocrystals. The excitation wavelength was 350 nm. On bromine alloying, the red tuning of the host emission is observed, but the dopant emission position remains fixed. However, drastic reduction in the Mn dopant emission is observed on bromine alloying. This is due to decrease in the efficiency of exciton to dopant energy transfer on reduction of bandgap due to bromine alloying.

### Example 7: Photoluminescence Excitation (PLE) Spectra

The origin of the Mn dopant emission position (600 nm) was selected for investigating the origin of this emission. Figure 4 presents PLE spectra of Mn-doped CsPbCl₃₋ₓBrₓ nanocrystals. The steady red shift in the spectra is well correlated with their corresponding absorbance spectra, which concludes that the emission is originated from the corresponding host nanocrystals.

### Example 8: Powder X-Ray Diffraction (XRD) Measurement

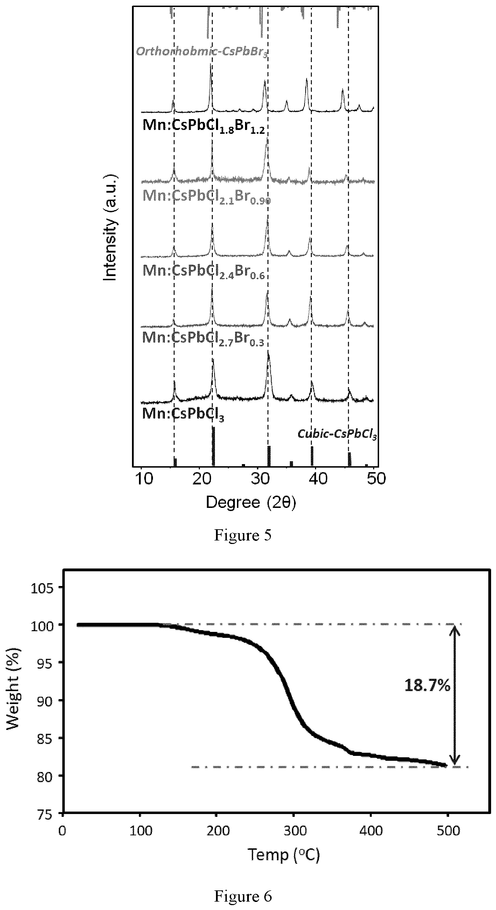

Figure 5 presents powder XRD patterns of Mn-doped CsPbCl₃₋ₓBrₓ nanocrystals. The lowering of 20 degree of the bromine alloying sample clearly demonstrates that the volume of the crystal expanded on bromine alloying and the targeted alloying process is achieved.

### Example 9: Yield Calculation

To calculate the exact yield of the nanocrystals, the reaction was performed using 0.5 mmole of Cs₂CO₃, 1 mmole of Pb(OAc)₂.3H₂O, and 0.05 mmole of Mn(OAc)₂.4H₂O precursors. After the reaction, the resulting product was purified by centrifugation (20000 rpm, 20min) using ethyl acetate as non-solvent (Ethyl acetate: reaction mixture = 4:1). The purified nanocrystals were dried inside vacuum oven at 80°C for overnight. The amount of ligand present along with the nanocrystals was calculated by weight loss in the Thermogravimetric analysis (TGA). Figure 6 discloses the TGA weight loss profile of the nanocrystals. The yield calculation is given in Table 1.

**Table 1. Yield Calculation**

| **Theoretical Yield** | **Product weight with ligand** | **Weight loss in TGA** | **Actual Yield** | **Yield Percentage** |
|---|---|---|---|---|
| 0.446 gm | 0.529gm | 18.70% | 0.435 | 97.5 |

| | | | | |
|---|---|---|---|---|
| Therefore, the process shows a yield of 97.5%. | | | | |

## Claims

1. A process for preparation of D-doped ABX₃ perovskite nanocrystals, the process comprising:
(a) loading non-halide precursors of A, B and D in a three-neck flask along with a long chain acid and a linear alpha olefin solvent to form a reaction mixture;
(b) purging the reaction mixture with an inert gas at a temperature in a range of 100-160°C for 30 minutes;
(c) injecting an alkylammonium halide solution in the reaction mixture at a temperature in a range of 80-200°C;
(d) annealing the reaction mixture for 5 seconds to 1 hour and cooling down naturally; and
(e) precipitating the D-doped ABX₃ nanocrystals.

2. The process as claimed in claim 1, wherein the non-halide precursors A and B are present in a ratio of 1: 1.

3. The process as claimed in claim 1 or 2, wherein D is present in a range of 5-50 wt.% with respect to A and B.

4. The process as claimed in any preceding claim, wherein A is selected from cesium (Cs) and formamidinium (FA); B is lead (Pb); and X is selected from chlorine (Cl), bromine (Br) and iodine (I).

5. The process as claimed in any preceding claim, wherein D is selected from manganese (Mn), nickel (Ni), cobalt (Co), iron (Fe), magnesium (Mg), beryllium (Be), calcium (Ca), strontium (Sr), barium (Ba), bismuth (Bi), antimony (Sb), cerium (Ce), samarium (Sm), europium (Eu), terbium (Tb), dysprosium (Dy), erbium (Er), ytterbium (Yb), zinc (Zn), cadmium (Cd), thallium (Tl), tin (Sn).

6. The process as claimed in any preceding claim, wherein the non-halide precursor source is selected from carbonate, acetate, nitrate, acetylacetonate, oleate, undecylenate, myristate, laurate, or palmitate.

7. The process as claimed in any preceding claim, wherein the long chain acid is selected from oleic acid, undecylenic acid, dodecanoic acid, hexadecanoic acid, or hexadecanoic acid.

8. The process as claimed in any preceding claim, wherein the linear alpha olefin solvent is selected from 1-decene, 1-dodecene, 1-tetradecene, 1-hexadecene, or 1-octadecene.

9. The process as claimed in any preceding claim, wherein the alkylammonium halide is selected from chloride or bromide or iodide salts of octylammonium, oleylammonium, dodecylammonium, dodecylamine, dihexylammonium, dioctylammonium, didecylammonium, or dioctdecylammonium.

10. The process as claimed in any preceding claim, wherein the process comprises preparation of D-doped AB¹_{1-y}B²_{y}X₃ perovskite nanocrystals, wherein B¹ comprises silver (Ag), sodium (Na) and potassium (K);
B₂ comprises indium (In), bismuth (Bi) and antimony (Sb); and
y = 0 to 1.
